# EUROPEAN PATENT SPECIFICATION

(11) **EP 1 464 688 B1**
(45) Date of publication and mention of the grant of the patent: **09.08.2006**
(21) Application number: 04007699.4
(22) Date of filing: 30.03.2004
(51) Int. Cl.: C09J 7/02

(54) **Heat-peelable double-faced pressure-sensitive adhesive sheet, method for adhering processed material onto said sheet, and electronic part**
Durch Wärmeeinwirkung wieder abziehbare druckempfindliche doppelseitige Klebefolie, Klebeverfahren von bearbeitetem Material mit der Klebefolie und elektronisches Bauteil
Feuille adhésive sensible à la pression thermo-pelable double face, procédé d'adhésion de matériau traité avec la feuille adhésive et composant électronique

(30) Priority: 31.03.2003 JP 2003093556
(43) Date of publication of application: 06.10.2004
(73) Proprietor: NITTO DENKO CORPORATION, Osaka (JP)
(72) Inventor: Kiuchi, Kazuyuki, Ibaraki-shi Osaka (JP); Fujita, Yutaka, Ibaraki-shi Osaka (JP)
(74) Representative: Grünecker, Kinkeldey, Stockmair & Schwanhäusser Anwaltssozietät

(56) References cited:
- EP-A- 0 612 823
- EP-A- 1 033 393
- EP-A- 1 126 001
- EP-A- 1 154 002
- EP-A- 1 354 925
- WO-A-02/33017

## Description

### FIELD OF THE INVENTION

The present invention relates to a heat-peelable double-faced pressure-sensitive adhesive sheet which has satisfactory adhesiveness, can be easily peeled off by heating at any desired time, and is effective in preventing the adherend from being fouled upon separation therefrom, and which, even when the adherend is, inparticular, a fragile processed material such as a semiconductor wafer, can impart excellent processability and transportability thereto. The invention further relates to a method of processing an adherend using the heat-peelable double-faced pressure-sensitive adhesive sheet and to an electronic part obtained by the processing method.

### BACKGROUND ART

Hitherto, adhesive sheets obtained by forming a radiation-curable pressure-sensitive adhesive layer or a pressure-sensitive adhesive layer containing a heat-expandable blowing agent on a substrate have been known as adhesive sheets for use in a method which comprises adhesively fixing a processed material comprising a semiconductor wafer or layer-built capacitor to an adhesive sheet through its pressure-sensitive adhesive layer, grinding or cutting the processed material into a given size, and then separating the processed material from the adhesive sheet to recover it (see patent document 1 to patent document 3).

The former adhesive sheet is used in such a manner that the adhesive layer is irradiated with, in particular, ultraviolet as a radiation to cure the adhesive and reduce its adhesive strength and to thereby facilitate the separation and recovery of the processed material. In the latter, the pressure-sensitive adhesive layer is foamed or expanded by heating to reduce its adhesive force. These two types of pressure-sensitive adhesive sheets each are thus intended to attain both of tenacious adhesive holding power sufficient for work processing and easy separation/recovery.

However, the radiation-curable pressure-sensitive adhesive sheet having a radiation-curable pressure-sensitive adhesive layer has slight residual adhesive strength after irradiation with a radiation and is hence unsuitable for use in applications where a very fragile adherend is processed and then separated, although it has excellent reliability because the fouling of the adherend (processed material) caused by the adhesive sheet upon peeling is exceedingly slight.

On the other hand, the heat-peelable pressure-sensitive adhesive sheet having a pressure-sensitive adhesive layer containing a heat-expandable agent comes to have virtually no adhesive strength through a heat treatment and is hence highly suitable for the processing/separation of fragile adherends. However, since there are cases where a finely particulate residue resulting from the cohesive failure of the pressure-sensitive adhesive and attributable to foaming is transferred to the adherend upon peeling, use of this pressure-sensitive adhesive sheet for adherends especially required to have high cleanness is avoided.
[Patent Document 1]
   JP-A-56-61468
[Patent Document 2]
   JP-A-56-61469
[Patent Document 3]
   JP-A-60-252681

### SUMMARY OF THE INVENTION

In recent years, many of the works relating to semiconductors and electronic parts are so fragile that there are an increasing number of cases where the adherend (processed material) which has processed cannot be transported by itself. There is hence a desire for an adherend-processing method by which even a fragile adherend can be easily transported and processed and which enables the adherend after the processing to be clean. Namely, there is an exceedingly strong desire for a pressure-sensitive adhesive sheet which can impart excellent processability to even a fragile processed material, can be easily peeled from the adherend after processing, and does not foul the adherend upon peeling therefrom.

Such a pressure-sensitive adhesive sheet preferably is one which has only the merits of each of the radiation-curable pressure-sensitive adhesive sheet and the heat-peelable pressure-sensitive adhesive sheet and which enables the adherend to be easily transported together with the pressure-sensitive adhesive sheet adherent thereto.

Accordingly, an object of the invention is to provide: a heat-peelable double-faced pressure-sensitive adhesive sheet which, even when the adherend is a fragile one, can impart excellent processability and transportability thereto and which can be easily peeled off when desired and is effective in inhibiting or preventing the adherend from being fouled upon separation therefrom, a method of processing an adherend using the heat-peelable double-faced pressure-sensitive adhesive sheet, and an electronic part obtained by the processing method.

Another object of the invention is to provide: a heat-peelable double-faced pressure-sensitive adhesive sheet especially suitable for use in the processing a semiconductor wafer by grinding or cutting, a method of processing an adherend using the heat-peelable double-faced pressure-sensitive adhesive sheet, and an electronic part obtained by the processing method.

The present inventors made intensive investigations in order to accomplish the objects described above. As a result, they have found that when a heat-peelable double-faced pressure-sensitive adhesive sheet obtained by forming a heat-peelable pressure-sensitive adhesive layer on one side of a substrate and forming a pressure-sensitive adhesive layer on the other side so as to have such constitution that the substrate is peeled from the heat-peelable pressure-sensitive adhesive layer by heating is used in the processing of a processed material, then this pressure-sensitive adhesive sheet shows satisfactory adhesiveness, can be easily peeled off by heating at any desired time, is effective in inhibiting that surface of the processed material which is separated from the adhesive sheet from being fouled upon peeling, and can enable the adherend to be processed with excellent processability and have satisfactory transportability even when the adherend is a fragile processed material, such as a semiconductor wafer. The invention has been completed based on these findings.

Namely, the invention provides a heat-peelable double-faced pressure-sensitive adhesive sheet which comprises a substrate (a), a heat-peelable pressure-sensitive adhesive layer (b) formed on one side thereof and containing heat-expandable microspheres, and a pressure-sensitive adhesive layer (c) formed on the other side, characterized in that the heat-peelable pressure-sensitive adhesive layer (b) and the substrate (a) are peelable from each other by heating.

In the heat-peelable double-faced pressure-sensitive adhesive sheet, a pressure-sensitive adhesive layer (d) has preferably been superposed on the heat-peelable pressure-sensitive adhesive layer (b) on its side opposite to the substrate (a).

The pressure-sensitive adhesive layer (d) preferably comprises at least one viscoelastic material selected from the group consisting of a pressure-sensitive adhesive, a radiation-curable pressure-sensitive adhesive,a thermoplastic resin, and a thermosetting resin.

The pressure-sensitive adhesive layer (c) preferably comprises at least one viscoelastic material selected from the group consisting of a pressure-sensitive adhesive, a radiation-curable pressure-sensitive adhesive, a thermosetting resin, and a heat-peelable pressure-sensitive adhesive.

The pressure-sensitive adhesive layer (c) may have a gel content (after a heat treatment or radiation exposure treatment) of 90% or higher. As the pressure-sensitive adhesive constituting the heat-peelable pressure-sensitive adhesive layer (b) can be advantageously used a radiation-curable pressure-sensitive adhesive. That side of the substrate (a) which faces the heat-peelable pressure-sensitive adhesive layer (b) may have undergone a releasability-imparting treatment.

The invention further provides a method of processing an adherend using the heat-peelable double-faced pressure-sensitive adhesive sheet described above, which comprises adhering the adherend to the surface of the pressure-sensitive adhesive layer (c) in the heat-peelable double-faced pressure-sensitive adhesive sheet, adhering a reinforcing plate to the surface of the heat-peelable pressure-sensitive adhesive layer (b) or pressure-sensitive adhesive layer (d), processing the adherend, subsequently causing separation at the interface between the heat-peelable pressure-sensitive adhesive layer (b) and the substrate (a) by heating, separating the processed adherend from the reinforcing plate together with, adherent thereto, the substrate (a) having the pressure-sensitive adhesive layer (c), and further separating the processed adherend from the substrate (a) having the pressure-sensitive adhesive layer (c).

The method of processing an adherend preferably comprises adhering the adherend to the surface of the pressure-sensitive adhesive layer (c) in the heat-peelable double-faced pressure-sensitive adhesive sheet, adhering a reinforcing plate to the surface of the heat-peelable pressure-sensitive adhesive layer (b) or pressure-sensitive adhesive layer (d), separating by heating the processed adherend from the reinforcing plate together with, adherent thereto, the substrate (a) having the pressure-sensitive adhesive layer (c) while supporting the processed adherend with a support, and further separating the processed adherend from the substrate (a) having the pressure-sensitive adhesive layer (c) while keeping the adherend in the state of being supported by the support. The adhesion of the adherend and/or the reinforcing plate to the given surface of the heat-peelable double-faced pressure-sensitive adhesive sheet may be conducted under reduced pressure. Furthermore, a heating and pressing may be conducted after the adherend and/or reinforcing plate is adhered to the given surface of the heat-peelable double-faced pressure-sensitive adhesive sheet. As the adherend can be advantageously used an electronic part or an analogue thereof.

Incidentally, it is preferred that the reinforcing plate to which the heat-peelable pressure-sensitive adhesive layer (b) and the pressure-sensitive adhesive layer (d) are adherent and which is obtained by causing separation at the interface between the heat-peelable pressure-sensitive adhesive layer (b) and the substrate (a) by heating be separated from the heat-peelable pressure-sensitive adhesive layer (b) and the pressure-sensitive adhesive layer (d) using a sheet or tape for peeling to thereby recover the reinforcing plate and this reinforcing plate recovered be reused in the processing of another adherend.

The invention furthermore includes: an electronic part characterized by being produced with the heat-peelable double-faced pressure-sensitive adhesive sheet described above; and an electronic part characterized by being produced by utilizing the method of processing an adherend described above.

### BRIEF DESCRIPTION OF THE DRAWINGS

Fig. 1 is a diagrammatic sectional view illustrating part of an embodiment of the heat-peelable double-faced pressure-sensitive adhesive sheet of the invention.
Fig. 2 is a diagrammatic sectional view illustrating part of an embodiment of the heat-peelable double-faced pressure-sensitive adhesive sheet of the invention.
Fig. 3 is a diagrammatic view illustrating an embodiment of the adherend-processing method of the invention.
Fig. 4 is a diagrammatic view illustrating an embodiment of the adherend-processing method of the invention.

In Figs., sign 1 is a heat-peelable double-faced pressure-sensitive adhesive sheet, sign 2 is a substrate (a), sign 3 is a heat-peelable pressure-sensitive adhesive layer (b), sign 4 is a pressure-sensitive adhesive layer (c), sign 5 is a pressure-sensitive adhesive layer (d), sign 6 is a separator, sign 7 is an adherend (processed material), sign 71 is a processed adherend, sign 8 is a reinforcing plate, sign 9 is a processed support for adherend 71.

### DETAILED DESCRIPTION OF THE INVENTION

Modes for carrying out the invention will be explained below in detail by reference to the drawings according to need. Like members, parts, and the like are often designated by like signs.

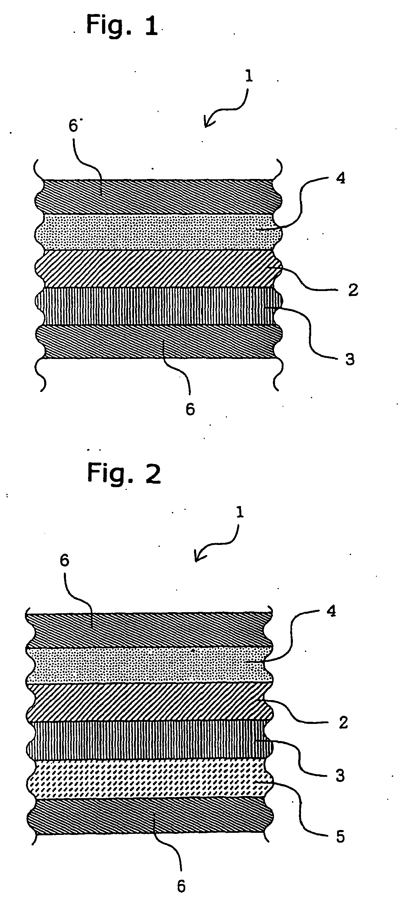

Fig. 1 and Fig. 2 each are a diagrammatic sectional view illustrating part of an embodiment of the heat-peelable double-faced pressure-sensitive adhesive sheet of the invention. In Fig. 1 and Fig. 2, 1 denotes a heat-peelable double-faced pressure-sensitive adhesive sheet, 2 a substrate (a), 3 a heat-peelable pressure-sensitive adhesive layer (b), 4 a pressure-sensitive adhesive layer (c), 5 a pressure-sensitive adhesive layer (d), and 6 a separator.

Specifically, the heat-peelable double-faced pressure-sensitive adhesive sheet 1 according to Fig. 1, comprises a substrate (a) 2, a heat-peelable pressure-sensitive adhesive layer (b) 3 formed on one side of the substrate (a) 2, a pressure-sensitive adhesive layer (c) 4 formed on the other side of the substrate (a) 2, and a separate 6 formed on each of the heat-peelable pressure-sensitive adhesive layer (b) 3 and the pressure-sensitive adhesive layer (c) 4, and has such a constitution that the heat-peelable pressure-sensitive adhesive layer (b) 3 can be peeled from the substrate (a) 2 by heating.

The heat-peelable double-faced pressure-sensitive adhesive sheet 1 according to Fig. 2 comprises a substrate (a) 2, a heat-peelable pressure-sensitive adhesive layer (b) 3 formed on one side of the substrate (a) 2, a pressure-sensitive adhesive layer (d) 5 formed on the heat-peelable pressure-sensitive adhesive layer (b) 3, a pressure-sensitive adhesive layer (c) 4 formed on the other side of the substrate (a) 2, and a separator 6 formed on each of the pressure-sensitive adhesive layer (d) 5 and the pressure-sensitive adhesive layer (c) 4, and has such a constitution that the heat-peelable pressure-sensitive adhesive layer (b) 3 can be peeled from the substrate (a) 2 by heating.

The heat-peelable double-faced pressure-sensitive adhesive sheet of the invention comprises a substrate (a), a heat-peelable pressure-sensitive adhesive layer (b) formed on one side of the substrate (a), a pressure-sensitive adhesive layer (d) optionally formed on the heat-peelable pressure-sensitive adhesive layer (b) on its side opposite to the substrate, and a pressure-sensitive adhesive layer (c) formed on the other side of the substrate (a), and has such a constitution that the heat-peelable pressure-sensitive adhesive layer (b) can be peeled from the substrate (a) by heating. As long as the heat-peelable double-faced pressure-sensitive adhesive sheet has the constitution described above, it can have a constitution which includes other layers (e.g., a rubbery organic elastic layer, pressure-sensitive adhesive layer, etc.), a separator, and the like disposed in appropriate positions according to need.

The heat-peelable double-faced pressure-sensitive adhesive sheet can be used for the case where an adherend is adhered to a reinforcing plate and processed. In such processing of an adherend, the pressure-sensitive adhesive layer (c) in the heat-peelable double-faced pressure-sensitive adhesive sheet can serve as a pressure-sensitive adhesive layer for adherend adhesion which is to be used for adhesion to the adherend, while the heat-peelable pressure-sensitive adhesive layer (b) or the pressure-sensitive adhesive layer (d) can serve as a pressure-sensitive adhesive layer for reinforcing plate adhesion which is to be used for adhesion to a reinforcing plate. Namely, the heat-peelable double-faced pressure-sensitive adhesive sheet can be used as a heat-peelable double-faced pressure-sensitive adhesive sheet for adherend processing.

Specifically, the heat-peelable double-faced pressure-sensitive adhesive sheet for adherend processing is a heat-peelable double-faced pressure-sensitive adhesive sheet which comprises a substrate (a), a heat-peelable pressure-sensitive adhesive layer (b) formed on one side of the substrate (a) and containing heat-expandable microspheres, and a pressure-sensitive adhesive layer (c) formed on the other side and is for use in the case where an adherend is adhered to a reinforcing plate and processed, and which is characterized in that the pressure-sensitive adhesive layer (c) is a pressure-sensitive adhesive layer for adherend adhesion to be used for adhesion to an adherend, that the heat-peelable pressure-sensitive adhesive layer (b) is a pressure-sensitive adhesive layer for reinforcing plate adhesion to be used for adhesion to a reinforcing plate, and that the heat-peelable pressure-sensitive adhesive layer (b) can be peeled from the substrate (a) by heating.

The heat-peelable double-faced pressure-sensitive adhesive sheet for adherend processing may have a constitution in which the heat-peelable pressure-sensitive adhesive layer (b) does not serve as a pressure-sensitive adhesive layer for reinforcing plate adhesion and a pressure-sensitive adhesive layer (d) has been superposed on the heat-peelable pressure-sensitive adhesive layer (b) on its side opposite to the substrate (a) so that this pressure-sensitive adhesive layer (d) serves as a pressure-sensitive adhesive layer for reinforcing plate adhesion to be used for adhesion to a reinforcing plate.

### [Substrate (a)]

The substrate (a) is not particularly limited as long as it neither deforms considerably nor flows during a heat treatment and can be easily peeled from the heat-peelable pressure-sensitive adhesive layer (b) by the heat treatment. Known substrates can be used. The substrate (a) may have a single-layer structure or a multilayer structure.

As the substrate (a) can be used an appropriate sheet material such as, for example, a plastic substrate such as a film or sheet of a plastic; a metallic substrate such as a metal foil, e.g., an aluminum foil or a nickel foil, or a metal sheet; a fibrous substrate such as a fabric, nonwoven fabric, net, or substrate made of aramid fibers; a paper substrate such as paper; a foam such as a foamed sheet; a laminate of these (in particular, a laminate of a plastic substrate with another substrate, a laminate of plastic films (or sheets), etc.); or the like. Preferably used as the substrate (a) is a plastic substrate such as a plastic film or sheet. Examples of materials in such plastic substrates include polyesters such as poly(ethylene terephthalate) (PET), poly(ethylene naphthalate) (PEN), and poly(butylene terephthalate) (PBT); polyimides; polyetherimides; poly(phenyl sulfate); amide resins such as polyamides (nylons) and wholly aromatic polyamides (aramids) ; poly(vinyl chloride) (PVC) ; poly (phenylene sulfide) (PPS) ; polyetheretherketones (PEEK) ; olefin resins formed from one or more monomer ingredients comprising an α-olefin, such as polyethylene (PE), polypropylene (PP), ethylene/propylene copolymers, and ethylene/vinyl acetate copolymers (EVA); fluororesins; silicone resins; and the like. These materials may be used alone or in combination of two or more thereof.

In the case where a radiation-curable substance is used in a pressure-sensitive adhesive layer, e.g., the heat-peelable pressure-sensitive adhesive layer (b) or pressure-sensitive adhesive layer (c), the substrate (a) to be used preferably is one which does not inhibit transmission of the radiation.

The thickness of the substrate (a) canbe suitably selected according to strength, flexibility, intended use, suitability for various operations, etc. The thickness thereof is usually selected in the range of about from 1 to 3,000 µm, preferably about from 10 to 1, 000 µm, from the standpoints of suitability for cutting, applicability, etc. However, the thickness is not limited to these.

In order for the substrate (a) to have better peelability from the heat-peelable pressure-sensitive adhesive layer (b), the side thereof facing the heat-peelable pressure-sensitive adhesive layer (b) may have undergone a coating treatment with a release agent such as a silicone release agent, fluorochemical release agent, or long-chain-alkyl type release agent (releasability-imparting treatment).

Furthermore, in order for the substrate (a) to have enhanced adhesion to the pressure-sensitive adhesive layer (c), the side thereof facing the pressure-sensitive adhesive layer (c) may have undergone a common surface treatment such as, e.g., a chemical or physical oxidation treatment such as a chromic acid treatment, exposure to ozone, exposure to a flame, exposure to a high-tension electric shock, or treatment with an ionizing radiation. That side may have undergone a coating treatment with a primer or the like.

### [Heat-Peelable Pressure-Sensitive Adhesive Layer (b)]

The heat-peelable pressure-sensitive adhesive layer (b) is a pressure-sensitive adhesive layer for use in adhesion to a reinforcing plate in processing an adherend (processed material), when a pressure-sensitive adhesive layer (d) has not been formed. Namely, in the case where the heat-peelable double-faced pressure-sensitive adhesive sheet does not have a pressure-sensitive adhesive layer (d), the heat-peelable pressure-sensitive adhesive layer (b) can function as a pressure-sensitive adhesive layer for adhesion to a reinforcing plate. In the case where a pressure-sensitive adhesive layer (d) has been formed on the heat-peelable pressure-sensitive adhesive layer (b), this pressure-sensitive adhesive layer (d) is utilized as a pressure-sensitive adhesive layer for adhesion to a reinforcing plate.

The heat-peelable pressure-sensitive adhesive layer (b) is a layer comprising a pressure-sensitive adhesive layer and, dispersed therein, heat-expandable microspheres (microcapsules) which expand by the action of heat. Namely, the heat-peelable pressure-sensitive adhesive layer (b) can be formed from a pressure-sensitive adhesive composition comprising at least a pressure-sensitive adhesive for imparting adhesive strength and heat-expandable microspheres (microcapsules) for imparting thermal expansibility. Consequently, by heating the heat-peelable pressure-sensitive adhesive layer (b) at any desired time to foam and/or expand the heat-expandable microspheres, the area of adhesion between the heat-peelable pressure-sensitive adhesive layer (b) and the substrate (a) can be reduced to thereby cause separation at the interface between the heat-peelable pressure-sensitive adhesive layer (b) and the substrate (a). Incidentally, blowing agents which are not in the form of microcapsules cannot stably impart satisfactory peelability.

### (Pressure-Sensitive Adhesive)

As the pressure-sensitive adhesive for the heat-peelable pressure-sensitive adhesive layer (b) can be used a pressure-sensitive adhesive which allows the heat-expandable microspheres to foam and/or expand upon heating. Especially preferred is one which restrains, as less as possible, the thermal foaming and/or expansion of the heat-expandable microspheres during heating. As such pressure-sensitive adhesive for use in forming the heat-peelable pressure-sensitive adhesive layer (b) can be employed one of or a combination of two or more of known pressure-sensitive adhesives such as, for example, rubber-based pressure-sensitive adhesives, acrylic pressure-sensitive adhesives, vinyl alkyl ether-based pressure-sensitive adhesives, silicone pressure-sensitive adhesives, polyester-based pressure-sensitive adhesives, polyamide-based pressure-sensitive adhesives, urethane-based pressure-sensitive adhesives, fluorochemical pressure-sensitive adhesives, styrene/diene block copolymer-based pressure-sensitive adhesives, and pressure-sensitive adhesives with improved creep characteristics obtained by incorporating a thermally meltable resin having a melting point of about 200°C or lower into those pressure-sensitive adhesives (see, for example, JP-A-56-61468, JP-A-61-174857, JP-A-63-17981, JP-A-56-13040, etc.).

Besides a polymeric ingredient such as a pressure-sensitive adhesive ingredient (base polymer), appropriate additives such as a crosslinking agent (e.g., a polyisocyanate, melamine alkyl ether, or the like), tackifier (e.g., one which is solid, semisolid, or liquid at ordinary temperature and comprises a rosin derivative resin, polyterpene resin, petroleum resin, oil-soluble phenolic resin, or the like), plasticizer, filler, and antioxidant may be contained in the pressure-sensitive adhesive according to the kind of the pressure-sensitive adhesive, etc. Incidentally, the pressure-sensitive adhesive maybe in any form such as an emulsion type pressure-sensitive adhesive, a solvent-based pressure-sensitive adhesive, or the like.

As the pressure-sensitive adhesive can generally be advantageously used: rubber-based pressure-sensitive adhesives employing natural rubber or various synthetic rubbers (e.g., polyisoprene rubber, styrene/butadiene rubbers, styrene/isoprene/styrene block copolymer rubbers, styrene/butadiene/styrene block copolymer rubbers, regenerated rubbers, butyl rubber, polyisobutylene, and the like) as the base polymer; and acrylic pressure-sensitive adhesives employing as the base polymer an acrylic polymer (homopolymer or copolymer) formed using one or more (meth)acrylic acid alkyl esters as monomer ingredients.

Examples of the (meth)acrylic acid alkyl esters in the acrylic pressure-sensitive adhesives include C₁₋₂₀ alkyl esters of (meth)acrylic acid, such as the methyl ester, ethyl ester, propyl ester, isopropyl ester, butyl ester, isobutyl ester, s-butyl ester, t-butyl ester, pentyl ester, hexyl ester, heptyl ester, octyl ester, 2-ethylhexyl ester, isooctyl ester, nonyl ester, isononyl ester, decyl ester, isodecyl ester, undecyl ester, dodecyl ester, tridecyl ester, tetradecyl ester, pentadecyl ester, hexadecyl ester, heptadecyl ester, octadecyl ester, nonadecyl ester, and eicosyl ester of (meth)acrylic acid [preferably C₄₋₈ alkyl (linear or branched alkyl) esters of (meth)acrylic acid] and the like.

Incidentally, the acrylic polymer may contain units corresponding to other monomer ingredients copolymerizable with the (meth)acrylic acid alkyl esters, for the purpose of improving cohesive force, heat resistance, crosslinkability, etc. Examples of such monomer ingredients include carboxyl group-containing monomers such as acrylic acid, methacrylic acid, carboxyethyl acrylate, carboxypentyl acrylate, itaconic acid, maleic acid, fumaric acid, and crotonic acid; acid anhydride group-containing monomers such as maleic anhydride and itaconic anhydride; hydroxyl group-containing monomers such as hydroxyethyl (meth)acrylate, hydroxypropyl (meth)acrylate, hydroxybutyl (meth)acrylate, hydroxyhexyl (meth)acrylate, hydroxyoctyl (meth)acrylate, hydroxydecyl (meth)acrylate, hydroxylauryl (meth)acrylate, and (4-hydroxymethylcyclohexyl)methyl methacrylate; sulfo group-containing monomers such as styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; phosphate group-containing monomers such as 2-hydroxyethyl acryloylphosphate; (N-substituted) amide monomers such as (meth)acrylamide, N,N-dimethyl (meth)acrylamide, N-butyl(meth)acrylamide, N-methylol(meth)acrylamide, and N-methylolpropane(meth)acrylamide; aminoalkyl (meth)acrylate monomers such as aminoethyl (meth)acrylate, N,N-dimethylaminoethyl (meth)acrylate, and t-butylaminoethyl (meth)acrylate; alkoxyalkyl (meth)acrylate monomers such as methoxyethyl (meth)acrylate and ethoxyethyl (meth)acrylate; maleimide monomers such as N-cyclohexylmaleimide, N-isopropylmaleimide, N-laurylmaleimide, and N-phenylmaleimide; itaconimide monomers such as N-methylitaconimide, N-ethylitaconimide, N-butylitaconimide, N-octylitaconimide, N-2-ethylhexylitaconimide, N-cyclohexylitaconimide, andN-laurylitaconimide; succinimide monomers such as N-(meth)acryloyloxymethylenesuccinimide, N-(meth)acryloyl-6-oxyhexamethylenesuccinimide, and N-(meth)acryloyl-8-oxyoctamethylenesuccinimide; vinyl monomers such as vinyl acetate, vinyl propionate, N-vinylpyrrolidone, methylvinylpyrrolidone, vinylpyridine, vinylpiperidine, vinylpyrimidine, vinylpiperazine, vinylpyrazine, vinylpyrrole, vinylimidazole, vinyloxazole, vinylmorpholine, N-vinylcarboxamides, styrene, α-methylstyrene, and N-vinylcaprolactam; cyanoacrylate monomers such as acrylonitrile and methacrylonitrile; epoxy group-containing acrylic monomers such as glycidyl (meth)acrylate; glycol acrylic ester monomers such as polyethylene glycol (meth)acrylate, polypropylene glycol (meth)acrylate, methoxyethylene glycol (meth)acrylate, and methoxypolypropylene glycol (meth)acrylate; acrylic ester monomers having one or more heterocycles, halogen atoms, or silicon atoms or the like, such as tetrahydrofurfuryl (meth)acrylate, fluorinated (meth)acrylates, and silicone (meth)acrylates; polyfunctional monomers such as hexanediol (meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylates, polyester acrylates, urethane acrylates, divinylbenzene, butyl di(meth)acrylate, and hexyl di (meth) acrylate; olefinic monomers such as isoprene, butadiene, and isobutylene; vinyl ether monomers such as vinyl ether; and the like. These monomer ingredients may be used alone, or two or more thereof may be used.

As the pressure-sensitive adhesive for forming the heat-peelable pressure-sensitive adhesive layer (b) may also be used a radiation-curable pressure-sensitive adhesive (or energy ray-curable pressure-sensitive adhesive). As the radiation-curable pressure-sensitive adhesive can be used the radiation-curable pressure-sensitive adhesives which will be specifically shown later. The radiation-curable pressure-sensitive adhesive is a pressure-sensitive adhesive which has adhesive strength and can be cured with a radiation (or energy ray), and which can come to have reduced adhesive force through curing with a radiation. Namely, when a radiation-curable pressure-sensitive adhesive is used as the pressure-sensitive adhesive for forming the heat-peelable pressure-sensitive adhesive layer (b), the pressure-sensitive adhesive is crosslinked and cured by a radiation exposure treatment to attain a decrease in adhesive force.

Additionally, in the heat-peelable pressure-sensitive adhesive layer (b), a more preferred pressure-sensitive adhesive, from the standpoint of a balance between moderate adhesive force before a heat treatment and the property of coming to have reduced adhesive force through the heat treatment, is a pressure-sensitive adhesive employing as the base a polymer having a dynamic modulus in the range of from 0.5 to 100 (Pa) at from room temperature to 150°C.

### (Heat-Expandable Microspheres)

The heat-expandable microspheres can be suitably selected from known heat-expandable microspheres. Preferred for use as the heat-expandable microspheres are blowing agents which have been microencapsulated. Examples of such heat-expandable microspheres include microspheres obtained by encapsulating a substance which upon heating readily gasifies and expands, such as, e.g., isobutane, propane, or pentane, in shells having elasticity. The shells are frequently constituted of a thermally meltable material or a material which breaks upon thermal expansion.

Examples of such materials constituting the shells include vinylidene chloride/acrylonitrile copolymers, poly(vinyl alcohol), poly(vinyl butyral), poly(methyl methacrylate), polyacrylonitrile, poly(vinylidene chloride), polysulfones, and the like. The heat-expandable microspheres can be produced by a common method such as, e.g., the coacervation method or interfacial polymerization method. There are commercial products of heat-expandable microspheres, such as, e.g., Matsumoto Microsphere [trade name; manufactured by Matsumoto Yushi-Seiyaku Co., Ltd.].

The particle diameter (average particle diameter) of the heat-expandable microspheres can be suitably selected according to the thickness of the heat-peelable pressure-sensitive adhesive layer (b), etc. From the standpoints of the impartation of surface smoothness to the heat-peelable pressure-sensitive adhesive layer (b), peelability, etc. the average particle diameter of the heat-expandable microspheres can be selected in the range of, for example, from 5 to 120 µm (preferably from 10 to 75 µm). The particle diameter regulation of the heat-expandable microspheres may be conducted in the course of the production of the heat-expandable microspheres or may be conducted after production by a technique such as classification.

From the standpoint of efficiently and stably reducing the adhesive force of the heat-peelable pressure-sensitive adhesive layer (b) by heating, it is preferred to use heat-expandable microspheres having such moderate strength that the microspheres do not break until the volume expansion ratio reaches 1.5 to 10 (preferably 2 to 5).

Incidentally, the amount of the heat-expandable microspheres to be incorporated can be suitably determined according to expansion ratio, the property of reducing the adhesive force of the heat-peelable pressure-sensitive adhesive layer (b), etc. In general, however, the amount thereof is, for example, from 5 to 200 parts by weight (preferably from 15 to 75 parts by weight) per 100 parts by weight of the polymeric ingredient constituting the heat-peelable pressure-sensitive adhesive layer (b) (e.g., the base polymer of the pressure-sensitive adhesive). Too large amounts of the heat-expandable microspheres incorporated are apt to cause the heat-peelable pressure-sensitive adhesive layer (b) to suffer cohesive failure of the pressure-sensitive adhesive. On the other hand, too small amounts thereof result in reduced peelability.

The heat-peelable pressure-sensitive adhesive layer (b) can be formed, for example, by a common method in which heat-expandable microspheres are mixed with a pressure-sensitive adhesive and optionally with a solvent, other additives, etc. and this mixture is formed into a sheet-form layer. Specifically, the heat-peelable pressure-sensitive adhesive layer (b) can be formed, for example, by a method in which a mixture comprising heat-expandable microspheres and a pressure-sensitive adhesive and optionally containing a solvent and other additives is applied to the substrate (a) or the like or a method in which the mixture is applied to an appropriate separator (e.g., release paper) to form a heat-peelable pressure-sensitive adhesive layer (b) and this layer is transferred (moved) to the substrate (a) or the like.

The thickness of the heat-peelable pressure-sensitive adhesive layer (b) can be suitably selected according to the property of reducing adhesive force, etc. For example, the thickness thereof is about 300 µm or smaller (preferably from 10 to 150 µm). In case where the thickness of the heat-peelable pressure-sensitive adhesive layer (b) is too large, a peeling operation after a heat treatment tends to result in cohesive failure. On the other hand, in case where the thickness of the heat-peelable pressure-sensitive adhesive layer (b) is too small, not only the degree of deformation of the heat-peelable pressure-sensitive adhesive layer (b) through a heat treatment is low and the adhesive force is less apt to smoothly decrease, but also the heat-expandable microspheres to be added are required to have an excessively small particle diameter. Incidentally, the heat-peelable pressure-sensitive adhesive layer (b) may have either a single-layer or multilayer structure.

### [Pressure-Sensitive Adhesive Layer (c)]

The pressure-sensitive adhesive layer (c) is a pressure-sensitive adhesive layer to be used for adhesion to the adherend (processed material) to be processed. Namely, the pressure-sensitive adhesive layer (c) functions as a pressure-sensitive adhesive layer for adhesion to an adherend. The pressure-sensitive adhesive layer (c) can be constituted of a viscoelastic material such as a pressure-sensitive adhesive, radiation-curable pressure-sensitive adhesive, thermoplastic resin, thermosetting resin, or heat-peelable pressure-sensitive adhesive, and is preferably constituted of a viscoelastic material such as a pressure-sensitive adhesive, radiation-curable pressure-sensitive adhesive, thermosetting resin, or heat-peelable pressure-sensitive adhesive. Such viscoelastic materials may be used alone or in combination of two or more thereof.

The viscoelastic material to be used for forming the pressure-sensitive adhesive layer (c) can be suitably selected according to pressure-sensitive adhesive properties on adherends (e.g., adhesive force, etc.), and is not particularly limited. However, a preferred viscoelastic material is one which can conform to surface irregularities of the substrate (a) and surface irregularities of adherends and can readily form a pressure-sensitive adhesive layer.

Preferred as such a viscoelastic material for the pressure-sensitive adhesive layer (c) among those shown above are a pressure-sensitive adhesive and a radiation-curable pressure-sensitive adhesive. As the heat-peelable pressure-sensitive adhesive can be used a heat-peelable pressure-sensitive adhesive comprising the pressure-sensitive adhesive composition for forming the heat-peelable pressure-sensitive adhesive layer (b).

As the pressure-sensitive adhesive for use in the pressure-sensitive adhesive layer (c) can be employed known or common pressure-sensitive adhesives such as, e.g., the pressure-sensitive adhesives shown as examples of pressure-sensitive adhesives for use in the heat-peelable pressure-sensitive adhesive layer (b) described above (e.g., rubber-based pressure-sensitive adhesives, acrylic pressure-sensitive adhesives, vinyl alkyl ether-based pressure-sensitive adhesives, silicone pressure-sensitive adhesives, polyester-based pressure-sensitive adhesives, polyamide-based pressure-sensitive adhesives, urethane-based pressure-sensitive adhesives, fluorochemical pressure-sensitive adhesives, styrene/diene block copolymer-based pressure-sensitive adhesives, pressure-sensitive adhesives with improved creep characteristics, radiation-curable pressure-sensitive adhesives, and the like).

A radiation-curable pressure-sensitive adhesive is a pressure-sensitive adhesive which has adhesive strength and can be cured with a radiation (or energy ray) as stated above. This pressure-sensitive adhesive can come to have reduced adhesive force through this curing with a radiation. Namely, the radiation-curable pressure-sensitive adhesive, through crosslinking and curing, is effective not only in diminishing contaminants for adherends (processed materials) but also in attaining a reduction in adhesive force according to need.

Examples of the radiation-curable pressure-sensitive adhesive include: a radiation-curable pressure-sensitive adhesive comprising a base (pressure-sensitive adhesive) containing a functional-group-containing compound containing crosslinkable functional groups, e.g., a polyfunctional monomer, and a radiation polymerization initiator incorporated in the base according to need; a radiation-curable pressure-sensitive adhesive comprising a pressure-sensitive adhesive having a polymeric ingredient obtained by copolymerization with a functional-group-containing compound containing crosslinkable functional groups, e.g., a polyfunctional monomer, as a monomer ingredient and a radiation polymerization initiator incorporated therein according to need; and the like.

As the radiation-curable pressure-sensitive adhesive can be advantageously used the radiation-curable pressure-sensitive adhesive which comprises a base (pressure-sensitive adhesive) containing a functional-group-containing compound containing crosslinkable functional groups, e.g., a polyfunctional monomer, and a radiation polymerization initiator incorporated in the base. As the base can be used, for example, rubber-based pressure-sensitive adhesive comprising natural rubber or a synthetic rubber; pressure-sensitive adhesives comprising a silicone rubber; acrylic pressure-sensitive adhesives comprising a homo- or copolymer of (meth)acrylic acid alkyl esters [e.g., C₁₋₂₀ alkyl esters of (meth)acrylic acid, such as the methyl ester, ethyl ester, propyl ester, isopropyl ester, butyl ester, isobutyl ester, hexyl ester, octyl ester, 2-ethylhexyl ester, isooctyl ester, isodecyl ester, and dodecyl ester] or a copolymer of one or more of the (meth)acrylic acid alkyl esters with one or more other monomers [e.g., monomers having a carboxyl group or acid anhydride group, such as acrylic acid, methacrylic acid, itaconic acid, maleic acid, fumaric acid, and maleic anhydride; hydroxyl group-containing monomers such as 2-hydroxyethyl (meth)acrylate; sulfo group-containing monomers such as styrenesulfonic acid; phosphate group-containing monomers such as 2-hydroxyethyl acryloylphosphate; amide group-containing monomers such as (meth)acrylamide; amino group-containing monomers such as aminoethyl (meth)acrylate; alkoxy group-containing monomers such as methoxyethyl (meth)acrylate; imide group-containing monomers such as N-cyclohexylmaleimide; vinyl esters such as vinyl acetate; vinyl group-containing heterocyclic compounds such as N-vinylpyrrolidone; styrene monomers such as styrene and α-methylstyrene; cyano group-containing monomers such as acrylonitrile; epoxy group-containing acrylic monomers such as glycidyl (meth)acrylate; vinyl ether monomers such as vinyl ether; and the like]; polyurethane-based pressure-sensitive adhesives; and the like. Preferred bases include acrylic pressure-sensitive adhesives. The base may be constituted of one ingredient or may be constituted of two or more ingredients.

The functional-group-containing compound containing crosslinkable functional groups may be a radiation-curable low-molecular compound or may be a radiation-curable resin. A radiation-curable low-molecular compound and a radiation-curable resin may be used in combination, or only either of these may be used. Radiation-curable low-molecular compounds and radiation-curable resins each may be used alone or in combination of two or more thereof.

The radiation-curable low-molecular compound is not particularly limited as long as it can be cured with an energy ray (radiation) such as visible light, ultraviolet, or electron beams. However, the compound preferably is one which enables the heat-peelable pressure-sensitive adhesive layer (b) to efficiently form a three-dimensional network through irradiation with an energy ray.

Specific examples of the radiation-curable low-molecular compound include trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, 1,4-butylene glycol diacrylate, 1,6-hexanediol diacrylate, polyethylene glycol diacrylate, and the like. Examples of the radiation-curable resin include polymers or oligomers having photosensitive reactive groups, such as ester (meth)acrylates having (meth)acrylol groups at molecular ends, urethane (meth)acrylates, epoxy (meth)acrylates, melamine (meth)acrylate, acrylic resin (meth)acrylates, thiol-ene addition resins or cationically photopolymerizable resins having allyl groups at molecular ends, cinnamoyl group-containing polymers such as poly(vinyl cinnamate), diazotized aminonovolac resins, acrylamide type polymers, and the like. Furthermore, examples of polymers reacting upon irradiation with a high-energy ray include epoxidized polybutadiene, unsaturated polyesters, poly(glycidyl methacrylate), polyacrylamide, polyvinylsiloxane, and the like. In the case where the radiation-curable resin is used, the base is not always necessary.

The amount of the functional-group-containing compound containing crosslinkable functional groups to be incorporated is, for example, in the range of about from 5 to 500 parts by weight, preferably from 15 to 300 parts by weight, more preferably from 20 to 150 parts by weight, based on 100 parts by weight of the base.

As the radiation-curable pressure-sensitive adhesive may also be used an ultraviolet (UV) -reactive pressure-sensitive adhesive polymer. Examples of the ultraviolet-reactive pressure-sensitive adhesive polymer include photosensitive acrylic pressure-sensitive adhesives obtained by incorporating a compound containing a photosensitive functional group such as a vinyl group into acrylic polymer molecules by a chemical reaction using active functional groups such as hydroxyl groups or carboxyl groups as starting sites. Ultraviolet-reactive pressure-sensitive adhesive polymers may be used alone or as a mixture of two or more thereof.

Examples of the radiation polymerization initiator include acetophenone type initiators such as 4-(2-hydroxyethoxy)phenyl (2-hydroxy-2-propyl) ketone, α-hydroxy-α,α'-dimethylacetophenone, methoxyacetophenone, 2,2-dimethoxy-2-phenylacetophenone, 2,2-diethoxyacetophenone, 1-hydroxycyclohexyl phenyl ketone, and 2-methyl-1-[4-(methylthio)phenyl]-2-morpholinopropane-1; benzoin ether type initiators such as benzoin ethyl ether, benzoin isopropyl ether, and anisoin methyl ether; α-ketol compounds such as 2-methyl-2-hydroxypropiophenone; ketal compounds such as benzyl dimethyl ketal; aromatic sulfonyl chloride compounds such as 2-naphthalenesulfonyl chloride; photo-active oxime compounds such as 1-phenone-1,1-propanedione-2-(o-ethoxycarbonyl) oxime; benzophenone type compounds such as benzophenone, benzoylbenzoic acid, and 3, 3'-dimethyl-4-methoxybenzophenone; and thioxanthone type compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone. Besides these, examples thereof further include camphorquinone, halogenated ketones, acylphosphinoxides, acylphosphonates, and the like.

Besides the ingredients shown above, appropriate additives such as a heat polymerization initiator, crosslinking agent, tackifier, and vulcanizing agent may have been incorporated in the radiation-curable pressure-sensitive adhesive according to need so as to obtain proper viscoelasticity before and after curing with a radiation. A radiation polymerization accelerator may be used in combination with the radiation polymerization initiator.

As the radiation-curable pressure-sensitive adhesive in the invention can be advantageously used a radiation-curable acrylic pressure-sensitive adhesive employing an acrylic pressure-sensitive adhesive as the base.

Incidentally, the pressure-sensitive adhesive to be used for forming the pressure-sensitive adhesive layer (c) preferably is one which restrains, as less as possible, the thermal deformation of the heat-peelable pressure-sensitive adhesive layer (b). As the pressure-sensitive adhesive for forming the pressure-sensitive adhesive layer (c) can be advantageously used an acrylic pressure-sensitive adhesive. This acrylic pressure-sensitive adhesive may be either an acrylic pressure-sensitive adhesive or an energy ray-curable acrylic pressure-sensitive adhesive. The pressure-sensitive adhesive to be used for forming the pressure-sensitive adhesive layer (c) may contain known or common additives such as, e.g., a plasticizer, filler, surfactant, antioxidant, and tackifier.

From the standpoint of diminishing the adherend fouling caused by free ingredients contained in the pressure-sensitive adhesive of the pressure-sensitive adhesive layer (c), it is preferred that the gel content of the pressure-sensitive adhesive layer (c) (after a heat treatment or radiation exposure treatment) be 90% or higher (preferably 95% by weight or higher).

The unit of the gel content is weight % (% by weight). The gel content means a weight ratio of a component which is insoluble in a solvent in a polymer wherein three-dimensional network structure is formed due to cross-linking between polymer chains.

The pressure-sensitive adhesive layer (c) can be formed, for example, by a technique in which a liquid pressure-sensitive adhesive is applied to the substrate (a) or by a method in which a pressure-sensitive adhesive layer (c) formed on an appropriate separator by the technique is transferred (moved) to the substrate (a).

The thickness of the pressure-sensitive adhesive layer (c) can be suitably selected according to the topology of the adherend surface, etc., and is not particularly limited. The thickness of the pressure-sensitive adhesive layer (c) can be selected, for example, in the range of about from 0.1 to 500 µm (preferably from 5 to 100 µm). Incidentally, the pressure-sensitive adhesive layer (c) may have either a single-layer structure or multilayer structure.

### [Pressure-Sensitive Adhesive Layer (d)]

The pressure-sensitive adhesive layer (d) is a pressure-sensitive adhesive layer for use in adhesion to a reinforcing plate in processing an adherend (processed material) Namely, the pressure-sensitive adhesive layer (d) has been formed on the heat-peelable pressure-sensitive adhesive layer (b) and functions as a pressure-sensitive adhesive layer for adhesion to a reinforcing plate. In a heat-peelable double-faced pressure-sensitive adhesive sheet having the constitution shown in Fig. 1, a treatment for peeling the heat-peelable pressure-sensitive adhesive layer (b) from the substrate (a) by heating results also in separation at the interface between the heat-peelable pressure-sensitive adhesive layer (b) and the reinforcing plate. As a result, the structure comes into the state of being separated into three units, i.e., a unit consisting of adherend/pressure-sensitive adhesive layer (c) /substrate (a), the heat-peelable pressure-sensitive adhesive layer (b), and the reinforcing plate. This necessitates a step for recovering the heat-peelable pressure-sensitive adhesive layer (b).

However, in a heat-peelable double-faced pressure-sensitive adhesive sheet having the constitution shown in Fig. 2, after a treatment for peeling the heat-peelable pressure-sensitive adhesive layer (b) from the substrate (a) by heating, the heat-peelable pressure-sensitive adhesive layer (b) retains the state of being adherent to the reinforcing plate through the pressure-sensitive adhesive layer (d). As a result, the structure comes into the state of being separated into two units, i.e., a unit consisting of adherend/pressure-sensitive adhesive layer (c)/substrate (a) and a unit consisting of heat-peelable pressure-sensitive adhesive layer (b)/pressure-sensitive adhesive layer (d) /reinforcing plate. A step for recovering the heat-peelable pressure-sensitive adhesive layer (b) is hence unnecessary and the efficiency of operation can be improved.

Like the pressure-sensitive adhesive layer (c), the pressure-sensitive adhesive layer (d) can be constituted of a viscoelastic material such as a pressure-sensitive adhesive, radiation-curable pressure-sensitive adhesive, thermoplastic resin, thermosetting resin, or heat-peelable pressure-sensitive adhesive. Such viscoelastic materials may be used alone or in combination of two or more thereof.

The pressure-sensitive adhesive layer (d) preferably is one which in its ordinary state is highly elastic or lowly tacky, and especially preferably is one which further has the property of being less contaminative. This is because when the pressure-sensitive adhesive layer (d) has the property of being less contaminative, the reinforcing plate can be easily subjected to reuse after recovery thereof.

Preferred as the viscoelastic material for the pressure-sensitive adhesive layer (d) among those shown above are a pressure-sensitive adhesive and a radiation-curable pressure-sensitive adhesive. The pressure-sensitive adhesive or radiation-curable pressure-sensitive adhesive to be used for the pressure-sensitive adhesive layer (d) can be the same as the pressure-sensitive adhesive or radiation-curable pressure-sensitive adhesive used in the pressure-sensitive adhesive layer (c).

The thickness of the pressure-sensitive adhesive layer (d) can be selected, for example, in the range of about from 0.1 to 100 µm (preferably from 5 to 50 µm). Incidentally, the pressure-sensitive adhesive layer (d) may have either a single-layer structure or multilayer structure.

### [Other Layers]

In the invention, the heat-peelable double-faced pressure-sensitive adhesive sheet may have other layers in appropriate positions according to need, as long as it has the constitution described above. Examples of other layers include interlayers or the like disposed between layers, for example, between the substrate (a) and the heat-peelable pressure-sensitive adhesive layer (b), between the substrate (a) and the pressure-sensitive adhesive layer (c), etc. Such other layers disposed may be of one kind or of two or more kinds. Such other layers each may consist of a single layer or may be composed of superposed layers.

Examples of the interlayers include a coating layer of a release agent for imparting releasability, a coating layer of a primer for improving adhesion, a flexible resin layer for imparting cushioning properties required for work processing, and the like. Other examples of the interlayers include a layer for imparting satisfactory deformability, a layer for increasing the area of adhesion to adherends, a layer for improving adhesive force, a layer for improving conformability to the surface shapes of adherends, a layer for improving the effect of an adhesive-force-reducing treatment with heating, a layer for improving peelability from the adherend after a heat treatment, etc. Incidentally, such other layers can be formed by known or commonmethods. Furthermore, the thicknesses and materials of such other layers are not particularly limited as long as the effects, advantages, and the like of the invention are not impaired thereby.

### [Separators]

In the invention, it is preferred that the heat-peelable pressure-sensitive adhesive layer (b), pressure-sensitive adhesive layer (c), and pressure-sensitive adhesive layer (d) be kept being protected with a separator until practical use from the standpoints of workability, dust-proofing, etc., as shown in Fig. 1 and Fig. 2. Namely, separators are used according to need, and need not be always disposed. The separators are stripped off when the heat-peelable double-faced pressure-sensitive adhesive sheet is applied to an adherend and a reinforcing plate.

As the separators can be used common release papers or the like. Specifically, as the separators can be used, for example, substrates having a release layer, such as plastic films and papers which have been surface-treated with a release agent such as a silicone, long-chain-alkyl, or fluorochemical release agent or molybdenum sulfide; lowly adhesive substrates made of fluoropolymers such as polytetrafluoroethylene, polychlorotrifluoroethylene, poly(vinyl fluoride), poly(vinylidene fluoride), tetrafluoroethylene/hexafluoropropylene copolymers, or chlorofluoroethylene/vinylidene fluoride copolymers; and lowly adhesive substrates made of nonpolar polymers such as polyolefin resins (e.g., polyethylene, polypropylene, and the like) or the like.

Incidentally, the separators can be formed by known or common methods. The separators are not particularly limited in thickness, etc.

The heat-peelable double-faced pressure-sensitive adhesive sheet of the invention is produced in an appropriate form, such as a sheet form or the form of a tape wound up into a roll. Incidentally, the heat-peelable double-faced pressure-sensitive adhesive sheet can be produced by using a generally known technique in which each layer is formed directly or disposed by transfer as stated above.

### [Method of Processing Adherend]

In the method of adherend processing of the invention, an adherend is adhered to a reinforcing plate through the heat-peelable double-faced pressure-sensitive adhesive sheet and this adherend is subjected to a processing treatment. Specifically, an adherend is adhered to the pressure-sensitive adhesive layer (c) side of the heat-peelable double-faced pressure-sensitive adhesive sheet, and a reinforcing plate is adhered to the heat-peelable pressure-sensitive adhesive layer (b) side or pressure-sensitive adhesive layer (d) side of the sheet. A processing treatment is given to the adherend while keeping the adherend in the state of being supported by the reinforcing plate. The adherend can hence be processed while retaining tenacious surface smoothness. Consequently, even when the adherend is a fragile processed material, a high-precision processing treatment can be easily given thereto.

After the processing treatment, a heat treatment is conducted to thereby cause separation at the interface between the heat-peelable pressure-sensitive adhesive layer (b) and the substrate (a) and separate the processed adherend from the reinforcing plate together with, adherent thereto through the pressure-sensitive adhesive layer (c), the substrate (a) having the pressure-sensitive adhesive layer (c). Furthermore, the processed adherend is separated from the substrate (a) having the pressure-sensitive adhesive layer (c).

Consequently, after a processing treatment is given to the adherend, this processed adherend can be easily separated from the reinforcing plate through a heat treatment at any desired time. In particular, since the substrate (a) is apparently adherent through the pressure-sensitive adhesive layer (c) to the processed adherend, the processed adherend can be temporarily recovered in the state of being supported by the substrate (a). Because of this, the processing method is excellent also in the transportability of the processed adherend.

Incidentally, since the adherend is adherent not to the heat-peelable pressure-sensitive adhesive layer (b) but to the pressure-sensitive adhesive layer (c), the adherend is inhibited or prevented from being fouled upon separation from the pressure-sensitive adhesive layer (c). Consequently, that side of the processed adherend which has separated from the pressure-sensitive adhesive sheet can be effectively made clean.

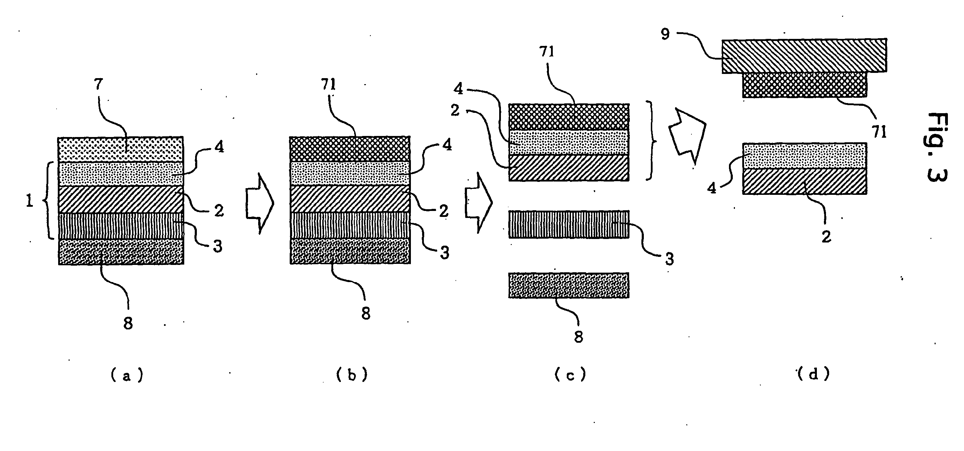

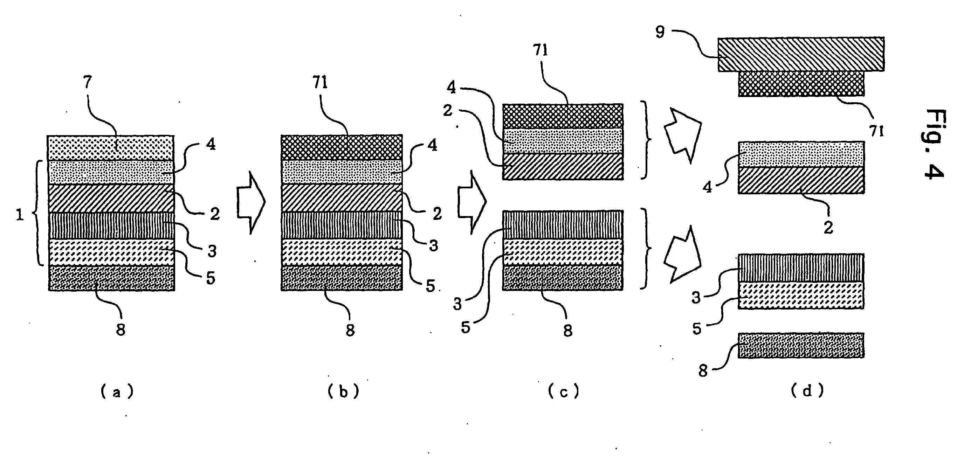

Embodiments of the method of adherend processing of the invention are shown in Fig. 3 and Fig. 4. Fig. 3 and Fig. 4 are diagrammatic views respectively illustrating adherend-processing methods according to the invention. Fig. 3 illustrates an embodiment in which the heat-peelable double-faced pressure-sensitive adhesive sheet shown in Fig. 1 is used, while Fig. 4 illustrates an embodiment in which the heat-peelable double-faced pressure-sensitive adhesive sheet shown in Fig. 2 is used. In Fig. 3 and Fig. 4, 7 denotes an adherend (processed material), 71 an adherend which has undergone a processing treatment, 8 a reinforcing plate, and 9 a support for the adherend 71 which has undergone a processing treatment, and 1 to 6 are the same as defined above.

In Fig. 3 and Fig. 4, an adherend 7 is adhered to a reinforcing plate 8 through a heat-peelable double-faced pressure-sensitive adhesive sheet 1, and a processing treatment is given to the adherend 7. Thereafter, this processed adherend 71 is separated, through a heat treatment while being supported by a support 9, from the reinforcing plate together with, adherent thereto through the pressure-sensitive adhesive layer (c), the substrate (a) having the pressure-sensitive adhesive layer (c).

Specifically, in Fig. 3, (a) shows an adherend 7 which is adherent to a reinforcing plate 8 through a heat-peelable double-faced pressure-sensitive adhesive sheet 1 of the constitution shown in Fig. 1 (the separators 6 have been stripped off). In (b), the adherend 7 shown in (a) above has become an adherend 71 which has undergone a processing treatment. In (c) is shown the state after a heat treatment conducted while supporting the processed adherend 71 in (b) above on a support 9.

Specifically, the heat treatment has caused separation at the interface between the heat-peelable pressure-sensitive adhesive layer (b) 3 and the substrate (a) 2 to obtain the processed adherend 71 together with, adherent thereto, the substrate (a) 2 having the pressure-sensitive adhesive layer (c) 4, and further caused separation also at the interface between the heat-peelable pressure-sensitive adhesive layer (b) 3 and the reinforcing plate 8 to obtain the heat-peelable pressure-sensitive adhesive layer (b) 3 and the reinforcing plate 8.

Namely, in Fig. 3, separation is caused by heating at the interface between the heat-peelable pressure-sensitive adhesive layer (b) and the substrate (a) to thereby separate the adherend from the reinforcing plate together with, adherent thereto, the substrate (a) having the pressure-sensitive adhesive layer (c). In this operation, however, since a pressure-sensitive adhesive layer (d) is not used, the heat-peelable pressure-sensitive adhesive layer (b) has been peeled also from the reinforcing plate and the reinforcing plate has been obtained independently. Consequently, in such cases, the reinforcing plate can be recovered through a single heat treatment and step simplification can be attained.

On the other hand, in Fig. 4, (a) shows an adherend 7 which is adherent to a reinforcing plate 8 through a heat-peelable double-faced pressure-sensitive adhesive sheet 1 of the constitution shown in Fig. 2. (the separators 6 have been peeled off). In (b), the adherend 7 shown in (a) above has become an adherend 71 which has undergone a processing treatment. In (c) is shown the state after a heat treatment conducted while supporting the processed adherend 71 in (b) above on a support 9. Specifically, the heat treatment has caused separation at the interface between the heat-peelable pressure-sensitive adhesive layer (b) 3 and the substrate (a) 2 to obtain the processed adherend 71 together with, adherent thereto, the substrate (a) 2 having the pressure-sensitive adhesive layer (c) 4 and further obtain the reinforcing plate together with, adherent thereto, the heat-peelable pressure-sensitive adhesive layer (b) and the pressure-sensitive adhesive layer (d).

Namely, in Fig. 4, since the pressure-sensitive adhesive layer (d) has been used, the separation of the adherend, together with adherent thereto the substrate (a) having the pressure-sensitive adhesive layer (c), from the reinforcing plate gives the reinforcing plate to which the heat-peelable pressure-sensitive adhesive layer (b) and the pressure-sensitive adhesive layer (d) are adherent.

In this case, since the heat-peelable pressure-sensitive adhesive layer (b) is not independently present in the step line, the fouling of the individual layers and apparatus can be inhibited or prevented. This processing method can hence be advantageously utilized in steps especially required to attain high cleanness. Incidentally, such a reinforcing plate to which the heat-peelable pressure-sensitive adhesive layer (b) and the pressure-sensitive adhesive layer (d) are adherent can be separated from the heat-peelable pressure-sensitive adhesive layer (b) and pressure-sensitive adhesive layer (d) by means of a known peeling technique such as a peeling technique utilizing, e.g., a sheet or tape for peeling. Thus, the reinforcing plate can be recovered.

In Fig. 3 and Fig. 4, the adherend which has undergone a processing treatment is separated from the reinforcing plate through a heat treatment while being supported by a support. However, this support may be used according to need, and need not be always used. For example, when the adherend is not too fragile and the processed adherend, even without being supported by a support, does not break upon separation from the reinforcing plate through a heat treatment, then a support need not be used. However, in the case where the adherend which has undergone a processing treatment is separated from the reinforcing plate through a heat treatment while being supported by a support as shown in Fig. 3 and Fig. 4, the adherend can be effectively inhibited or prevented from being damaged and be easily recovered or sent to the next step even when the adherend is fragile. Consequently, by use of a support, the transportability of the adherend which has undergone a processing treatment can be further improved.

Incidentally, in the case where the adherend is supported by a support, the processed adherend immediately after separation from the reinforcing plate is in such a state that it has the support on one side and has the substrate (a) on the other side through the pressure-sensitive adhesive layer (c). This processed adherend can be separated, in the state of being supported by the support, from the substrate (a) having the pressure-sensitive adhesive layer (c) by a known separation method according to the kind of the pressure-sensitive adhesive layer (c), etc.

Furthermore, the adherend which has undergone a processing treatment obtained by the separation is separated from the support disposed on one side thereof, by using a separation technique suitable for the supporting method (e.g., in the case where the supporting by the support is based on adhesion or suction, a technique for eliminating the adhesion or suction is used). Thus, the processed adherend can be obtained independently.

Furthermore, methods for adhering an adherend to a reinforcing plate through the heat-peelable double-faced pressure-sensitive adhesive sheet are not particularly limited. However, use can be made, for example, of a method in which one member of an adherend and a reinforcing plate (in particular, a rigid body such as a semiconductor wafer or the like) is adhered to a given side of the heat-peelable double-faced pressure-sensitive adhesive sheet by a known adhesion technique such as a roller press bonding method and the other member is subsequently adhered to a given side of the heat-peelable double-faced pressure-sensitive adhesive sheet in an atmosphere having a reduced pressure (especially, vacuum atmosphere). By thus conducting the adhesion of the adherend and/or reinforcing plate to a given side of the heat-peelable double-faced pressure-sensitive adhesive sheet at a reduced pressure, air bubble inclusion into the interface between the pressure-sensitive adhesive layer and the adherend or reinforcing plate can be inhibited or prevented.

In particular, even when air bubbles slightly come into the interface between a pressure-sensitive adhesive layer and the adherend or reinforcing plate, these air bubbles present in a slight amount can be diffused into the pressure-sensitive adhesive layer by conducting a heating and pressing treatment after the adherend and/or reinforcing plate is adherend to the given side of the heat-peelable double-faced pressure-sensitive adhesive sheet. Thus, the precision of adherend processing can be further improved.

By the adherend-processing method described above, various articles are produced according to the kinds of adherends, processing treatment methods, etc. Articles produced by utilizing the adherend-processing method described above (i.e., by using the heat-peelable double-faced pressure-sensitive adhesive sheet described above) are as follows. For example, in the case where electronic parts shown below, such as semiconductor wafers, are used as adherends, articles produced by utilizing the adherend-processing method (i.e., by using the heat-peelable double-faced pressure-sensitive adhesive sheet) are electronic parts (e.g., electronic parts having a semiconductor chip, or the like). Consequently, the heat-peelable double-faced pressure-sensitive adhesive sheet of the invention can be advantageously used for the grinding or cutting of semiconductor wafers.

### [Adherend]

The adherend (processed material) is not particularly limited, and may be, for example, a fragile processed material. Specific examples of the adherend include semiconductor wafers (such as silicon wafers), multilayered substrates, layered ceramics, electronic parts such a swhole-encapsulation modules, and the like. Adherends may be used alone or in combination of two or more thereof.

The processing treatment of the adherend is not particularly limited. For example, various processing treatments such as the grinding or cutting of semiconductor wafers (e.g., treatments of semiconductor wafers, such as processing for back polishing treatment, grinding processing for thickness reduction, processing for dicing treatment, microprocessing, and cutting processing) can be utilized.

### [Reinforcing Plate]

Examples of the reinforcing plate include glass plates such as sapphire glass plates and synthetic quartz plates; plastic plates such as polycarbonate plates and poly(methyl methacrylate) plates; metallic plates such as aluminum plates and SUS stainless-steel plates; silicone wafers; and the like. Reinforcing plates may be used alone or in combination of two or more thereof. The size of the reinforcing plate is preferably equal to or larger than the size of the adherend.

Incidentally, the reinforcing plate recovered can be reused for the processing of another adherend. Since the reinforcing plate in the invention can be easily recovered and reused, even a reinforcing plate made of an expensive material, such as a sapphire glass plate, can be used to attain a cost reduction and can be advantageously used as a reinforcing plate.

### [Support]

The support is not particularly limited. However, known supports such as, e.g., pressure-sensitive adhesive sheets or tapes or suction stages can be used. Namely, as a device for supporting on a support, use can be made of an adhesion device, suction device, or the like. Supports can be used alone or in combination of two or more thereof.

As a method for the heat treatment to be conducted for causing separation at the interface between the heat-peelable pressure-sensitive adhesive layer (b) and the substrate (a) after an adherend such as an electronic part is adhered to a reinforcing plate with the heat-peelable double-faced pressure-sensitive adhesive sheet and subjected to a processing treatment, use can be made of a heat treatment method utilizing an appropriate heating device such as, e.g., a hot plate, hot-air drying oven, near-infrared lamp, or air dryer. Any temperature may be used for the heating as long as it is not lower than the expansion initiation temperature of the heat-expandable microspheres in the heat-peelable pressure-sensitive adhesive layer (b). However, conditions for the heat treatment can be suitably determined according to the decrease in adhesion area, which depends on the surface state of the adherend, kind of the heat-expandable microspheres, etc., and to the heat resistance of the substrate (a) and adherend, method of heating (e.g., heat capacity, heating device, etc.), etc.

General conditions for the heat treatment include a temperature of from 100 to 250°C and a period of from 1 to 90 seconds (hot plate or the like) or from 5 to 15 minutes (hot-air drying oven or the like). The heat-expandable microspheres in the heat-peelable pressure-sensitive adhesive layer (b) expand and/or foam usually under such heating conditions and the heat-peelable pressure-sensitive adhesive layer (b) expands/deforms and thereby comes to have recesses and protrusions, whereby the adhesive force is reduced or lost. Incidentally, a heat treatment can be conducted in an appropriate stage according to intended use. Furthermore, there are cases where an infrared lamp or heating water can be used as a heating source.

According to the heat-peelable double-faced pressure-sensitive adhesive sheet of the invention, excellent processability and transportability can be imparted even to fragile adherends. Furthermore, the pressure-sensitive adhesive sheet can be easily peeled off when desired and is inhibited or prevented from fouling the adherend upon peeling. In particular, the heat-peelable double-faced pressure-sensitive adhesive sheet is suitable for use in the processing of semiconductor wafers by grinding for thinning or by cutting.

### EXAMPLES

The invention will be explained below in more detail based on Examples, but the invention should not be construed as being limited by these Examples in any way.

### (EXAMPLE 1)

A hundred parts by weight of an acrylic polymer having carbon-carbon double bonds (C=C bonds) in the molecule [an acrylic polymer having carbon-carbon double bonds (C=C bonds) in the molecule which had been formed from 75 parts by weight of ethyl acrylate, 25 parts by weight of 2-ethylhexyl acrylate, and 18 parts by weight of 2-hydroxybutyl acrylate as monomer ingredients and in which methacryloyloxyethylene isocyanate had added to 0.8 equivalents of the 2-hydroxybutyl acrylate; weight-average molecular weight, 950, 000] was compounded with 3 parts by weight of a polyurethane crosslinking agent (trade name "Coronate L", manufactured by Nippon Polyurethane Co., Ltd.) and 2.5 parts by weight of a photopolymerization initiator (trade name "Irgacure 651", manufactured by CIBA-GEIGY (Japan) Ltd.). Thus, an ultraviolet-reactive pressure-sensitive adhesive (sometimes referred to as "ultraviolet-reactive pressure-sensitive adhesive A") was obtained.

Furthermore, 100 parts by weight of an acrylic polymer (weight-average molecular weight, 500,000) formed from 50 parts by weight of ethyl acrylate, 50 parts by weight of butyl acrylate, and 5 parts by weight 2-hydroxyethyl acrylate as monomer ingredients was compounded with 3 parts by weight of a polyurethane crosslinking agent (trade name "Coronate L", manufactured by Nippon Polyurethane Co., Ltd.) and 25 parts by weight of heat-expandable microspheres (trade name "Matsumoto Microsphere F30D", manufactured by Matsumoto Yushi-Seiyaku Co., Ltd.; 90°C expansion type). Thus, a heat-peelable pressure-sensitive adhesive (sometimes referred to as "heat-peelable pressure-sensitive adhesive A") was obtained.

The ultraviolet-reactive pressure-sensitive adhesive A was applied to one side of a 38 µm-thick film made of poly(ethylene terephthalate) (PET film) in a thickness of 30 µm on a dry basis. Furthermore, the heat-peelable pressure-sensitive adhesive A was applied to the other side of the PET film in a thickness of 50 µm on a dry basis. Thus, a heat-peelable double-faced pressure-sensitive adhesive sheet (sometimes referred to as "pressure-sensitive adhesive sheet A") was obtained. Namely, this pressure-sensitive adhesive sheet A has a heat-peelable pressure-sensitive adhesive A layer (thickness, 50 µm) on one side of the PET film as a substrate and an ultraviolet-reactive pressure-sensitive adhesive A layer (thickness, 30 µm) on the other side thereof, and has such a constitution that the heat-peelable pressure-sensitive adhesive A layer can be peeled from the PET film by heating.

Subsequently, a semiconductor silicon wafer was adhered to the ultraviolet-reactive pressure-sensitive adhesive A layer (thickness, 30 µm) of the pressure-sensitive adhesive sheet A. Thereafter, the heat-peelable pressure-sensitive adhesive A layer (thickness, 50 µm) was adhered to a glass wafer using a vacuum laminator.

### (EXAMPLE 2)

A hundred parts by weight of an acrylic polymer (weight-average molecular weight, 1,150,000) formed from 40 parts by weight of butyl acrylate, 60 parts by weight of 2-ethylhexyl-acrylate, and 7 parts by weight of 2-hydroxyethyl acrylate as monomer ingredients was compounded with 5 parts by weight of a polyurethane crosslinking agent (trade name "Coronate L", manufactured by Nippon Polyurethane Co., Ltd.). Thus, a pressure-sensitive adhesive (sometimes referred to as "Pressure-sensitive adhesive B") was obtained.

A heat-peelable double-faced pressure-sensitive adhesive sheet (sometimes referred to as "pressure-sensitive adhesive sheet B") was obtained in the same manner as in Example 1, except that the pressure-sensitive adhesive B was used in place of the ultraviolet-reactive pressure-sensitive adhesive A. Namely, this pressure-sensitive adhesive sheet B has a heat-peelable pressure-sensitive adhesive A layer (thickness, 50 µm) on one side of the PET film as a substrate and a pressure-sensitive adhesive B layer (thickness, 30 µm) on the other side thereof, and has such a constitution that the heat-peelable pressure-sensitive adhesive A layer can be peeled from the PET film by heating.

Furthermore, a semiconductor silicon wafer and a glass wafer were adhered to the respective given adhesion sides in the same manner as in Example 1, except that the pressure-sensitive adhesive sheet B was used. Specifically, a semiconductor wafer was adhered to the pressure-sensitive adhesive B layer (thickness, 30 µm) of the pressure-sensitive adhesive sheet B and a glass wafer was adhered to the heat-peelable pressure-sensitive adhesive A layer (thickness, 50 µm).

### (EXAMPLE 3)

The heat-peelable pressure-sensitive adhesive A layer of the pressure-sensitive adhesive sheet A obtained in Example 1 was further coated with the ultraviolet-reactive pressure-sensitive adhesive A in a thickness of 15 µm on a dry basis to obtain a heat-peelable double-faced pressure-sensitive adhesive sheet (sometimes referred to as "pressure-sensitive adhesive sheet C").

Namely, this pressure-sensitive adhesive sheet C has a heat-peelable pressure-sensitive adhesive A layer (thickness, 50 µm) and an ultraviolet-reactive pressure-sensitive adhesive A layer (thickness, 15 µm) superposed in this order on one side of the PET film as a substrate and has an ultraviolet-reactive pressure-sensitive adhesive A layer (thickness, 30 µm) on the other side thereof, and has such a constitution that the heat-peelable pressure-sensitive adhesive A layer can be peeled from the PET film by heating.

Furthermore, a semiconductor silicon wafer and a glass wafer were adhered to the respective given adhesion sides in the same manner as in Example 1, except that the pressure-sensitive adhesive sheet C was used. Specifically, a semiconductor silicon wafer was adhered to the ultraviolet-reactive pressure-sensitive adhesive A layer (thickness, 30 µm) of the pressure-sensitive adhesive sheet C and a glass wafer was adhered to the ultraviolet-reactive pressure-sensitive adhesive A layer (thickness, 15 µm).

### (COMPARATIVE EXAMPLE 1)

A double-faced pressure-sensitive adhesive sheet (sometimes referred to as "pressure-sensitive adhesive sheet D") was obtained in the same manner as in Example 1, except that the pressure-sensitive adhesive B obtained in Example 2 was used in place of the heat-peelable pressure-sensitive adhesive A. Namely, this pressure-sensitive adhesive sheet D has a pressure-sensitive adhesive B layer (thickness, 50 µm) on one side of the PET film as a substrate and an ultraviolet-reactive pressure-sensitive adhesive A layer (thickness, 30 µm) on the other side. It does not have the property of being thermally peeled off by heating.

Furthermore, a semiconductive silicon wafer and a glass wafer were adhered to the given adhesion sides in the same manner as in Example 1, except that the pressure-sensitive adhesive sheet D was used. Specifically, a semiconductor silicon wafer was adhered to the ultraviolet-reactive pressure-sensitive adhesive A layer (thickness, 30 µm) of the pressure-sensitive adhesive sheet D and a glass wafer was adhered to the pressure-sensitive adhesive B layer (thickness, 50 µm).

### (COMPARATIVE EXAMPLE 2)

A double-faced pressure-sensitive adhesive sheet (sometimes referred to as "pressure-sensitive adhesive sheet E") was obtained in the same manner as in Example 1, except that the ultraviolet-reactive pressure-sensitive adhesive A was used in place of the heat-peelable pressure-sensitive adhesive A.

Namely, this pressure-sensitive adhesive sheet E has an ultraviolet-reactive pressure-sensitive adhesive A layer (thickness, 50 µm) on one side of the PET film as a substrate and an ultraviolet-reactive pressure-sensitive adhesive A layer (thickness, 30 µm) on the other side. It does not have the property of being thermally peeled off by heating.

Furthermore, a semiconductive silicon wafer and a glass wafer were adhered to the given adhesion sides in the same manner as in Example 1, except that the pressure-sensitive adhesive sheet E was used. Specifically, a semiconductor silicon wafer was adhered to the ultraviolet-reactive pressure-sensitive adhesive A layer (thickness, 30 µm) of the pressure-sensitive adhesive sheet E and a glass wafer was adhered to the ultraviolet-reactive pressure-sensitive adhesive A layer (thickness, 50 µm).

### (Adhesive strength Measurement)

Each of the pressure-sensitive adhesive sheets (pressure-sensitive adhesive sheets A to E) obtained in the Examples and Comparative Examples was cut into a width of 20 mm. A silicon mirror wafer was adhered to a given pressure-sensitive adhesive layer [the ultraviolet-reactive pressure-sensitive adhesive A layer (thickness, 30µm) inExample 1 and Example 3; the pressure-sensitive adhesive B layer (thickness, 30 µm) in Example 2; and the ultraviolet-reactive pressure-sensitive adhesive A layer (thickness, 30 µm) in Comparative Example 1 and Comparative Example 2]. Thereafter, the pressure-sensitive adhesive sheet was examined for 180° peel adhesive strength (peel rate, 300 mm/min; 23°C). The adhesive strength measurements for all the samples other than that of Example 2 were made after ultraviolet irradiation (integrated quantity of light, 30 mJ/cm²). The results of the measurements are shown in the row "Adhesive strength" in Example 1.

### (Evaluation of Peelability)

The surface of the semiconductor silicon wafer in the adhered unit obtained in each of the Examples and Comparative Examples, which had the constitution composed of "semiconductor silicon wafer/pressure-sensitive adhesive sheet/glass wafer", was ground with a back grinder ("DFG840", manufactured by DISCO Corp.) to a thickness of 40 µm. Subsequently, the glass wafer was separated by heating (30-second heating on a 100°C hot plate). Thereafter, a mount peeler ("PM8500", manufactured byNittoSeiki Inc.) was used to separate the 40-µm semiconductor silicon wafer. As a transfer tape for the 40 µm-thick semiconductor silicon wafer was used a dicing tape ("DU200", manufactured by Nitto Denko Corp.)

Semiconductor wafer grindability in grinding the semiconductor silicon wafer to a thickness of 40 µm, glass wafer peelability in separating the glass wafer by heating, and semiconductor silicon wafer peelability in separating the semiconductor silicon wafer with the mount peeler were evaluated. The results of the evaluations are shown in the rows "Silicon wafer grindability", "Glass wafer peelability", and "Silicon wafer peelability", respectively, in Table 1.

**Table 1**

| | Example | | | Comparative Example | |
|---|---|---|---|---|---|
| | 1 | 2 | 3 | 1 | 2 |
| Adhesive strength (N/20 mm) | 0.12 | 0.89 | 0.10 | 0.12 | 0.90 |
| Silicon wafer grindability | good | good | good | good | good |
| Glass wafer peelability | good | good | good | unable to be separated | unable to be separated |
| Silicon wafer peelability | good | good | good | unable to be separated | unable to be separated |

Table 1 shows the following. The pressure-sensitive adhesive sheets according to the Examples were utterly satisfactory in the wafer grindability in silicon wafer grinding to 40 µm, and were utterly satisfactory also in the peelability in the separation of the 40 µm-thick semiconductor silicon wafer from the heat-peelable pressure-sensitive adhesive sheet. Even though the semiconductor silicon wafer had a thickness of 40 µm, it could be separated without being damaged. The glass wafer peelability also was utterly satisfactory of course, and the wafer could be satisfactorily separated.

In contrast, in the pressure-sensitive adhesive sheets according to the Comparative Examples, the glass wafer as a reinforcing plate could not be separated although the wafer grindability in semiconductor silicon wafer grinding to 40 µm was satisfactory. Because of this, the semiconductor silicon wafer also could not be separated.

This application is based on Japanese patent applications No. 2003-093556 filed on March 31, 2003.

## Claims

1. A heat-peelable double-faced pressure-sensitive adhesive sheet which comprises a substrate (a), a heat-peelable pressure-sensitive adhesive layer (b) formed on one side of the substrate (a) and containing heat-expandable microspheres, and a pressure-sensitive adhesive layer (c) formed on the other side of the substrate (a), wherein the heat-peelable pressure-sensitive adhesive layer (b) and the substrate (a) are peelable from each other by heating.

2. The heat-peelable double-faced pressure-sensitive adhesive sheet according to claim 1, which further comprises a pressure-sensitive adhesive layer (d) superposed on the heat-peelable pressure-sensitive adhesive layer (b) on its side opposite to the substrate (a).

3. The heat-peelable double-faced pressure-sensitive adhesive sheet according to claim 2, wherein the pressure-sensitive adhesive layer (d) comprises at least one viscoelastic material selected from the group consisting of a pressure-sensitive adhesive, a radiation-curable pressure-sensitive adhesive, a thermoplastic resin, and a thermosetting resin.

4. The heat-peelable double-faced pressure-sensitive adhesive sheet according to any one of claims 1 to 3, wherein the pressure-sensitive adhesive layer (c) comprises at least one viscoelastic material selected from the group consisting of a pressure-sensitive adhesive, a radiation-curable pressure-sensitive adhesive, a thermosetting resin, and a heat-peelable pressure-sensitive adhesive.

5. The heat-peelable double-faced pressure-sensitive adhesive sheet according to any one of claims 1 to 3, wherein the gel content of the pressure-sensitive adhesive layer (c) (after a heat treatment or radiation exposure treatment) is 90% or higher.

6. The heat-peelable double-faced pressure-sensitive adhesive sheet according to any one of claims 1 to 3, wherein the pressure-sensitive adhesive constituting the heat-peelable pressure-sensitive adhesive layer (b) is a radiation-curable pressure-sensitive adhesive.

7. The heat-peelable double-faced pressure-sensitive adhesive sheet according to any one of claims 1 to 3, wherein that side of the substrate (a) which faces the heat-peelable pressure-sensitive adhesive layer (b) has undergone a releasability-imparting treatment.

8. A method of processing an adherend using the heat-peelable double-faced pressure-sensitive adhesive sheet according to any one of claims 1 to 3, which comprises adhering the adherend to the surface of the pressure-sensitive adhesive layer (c) in the heat-peelable double-faced pressure-sensitive adhesive sheet, adhering a reinforcing plate to the surface of the heat-peelable pressure-sensitive adhesive layer (b) or pressure-sensitive adhesive layer (d), processing the adherend, subsequently causing separation at the interface between the heat-peelable pressure-sensitive adhesive layer (b) and the substrate (a) by heating, separating the processed adherend from the reinforcing plate together with, adherent thereto, the substrate (a) having the pressure-sensitive adhesive layer (c), and further separating the processed adherend from the substrate (a) having the pressure-sensitive adhesive layer (c).

9. The method of processing an adherend according to claim 8, which comprises adhering the adherend to the surface of the pressure-sensitive adhesive layer (c) in the heat-peelable double-faced pressure-sensitive adhesive sheet, adhering a reinforcing plate to the surface of the heat-peelable pressure-sensitive adhesive layer (b) or pressure-sensitive adhesive layer (d), separating by heating the processed adherend from the reinforcing plate together with, adherent thereto, the substrate (a) having the pressure-sensitive adhesive layer (c) while supporting the processed adherend with a support, and further separating the processed adherend from the substrate (a) having the pressure-sensitive adhesive layer (c) while keeping the adherend in the state of being supported by the support.

10. The method of processing an adherend according to claim 8, wherein the adhesion of the adherend and/or the reinforcing plate to the given surface of the heat-peelable double-faced pressure-sensitive adhesive sheet is conducted under reduced pressure.

11. The method of processing an adherend according to claim 8, wherein a heating and pressing treatment is conducted after the adherend and/or reinforcing plate is adhered to the given surface of the heat-peelable double-faced pressure-sensitive adhesive sheet.

12. The method of processing an adherend according to claim 8, wherein the adherend is an electronic part or an analogue thereof.

13. The method of processing an adherend according to claim 8, wherein the reinforcing plate to which the heat-peelable pressure-sensitive adhesive layer (b) and the pressure-sensitive adhesive layer (d) are adherent and which is obtained by causing separation at the interface between the heat-peelable pressure-sensitive adhesive layer (b) and the substrate (a) by heating is separated from the heat-peelable pressure-sensitive adhesive layer (b) and the pressure-sensitive adhesive layer (d) using a sheet or tape for peeling to thereby recover the reinforcing plate and this reinforcing plate recovered is reused in the processing of another adherend.

14. An electronic part, which is produced with the heat-peelable double-faced pressure-sensitive adhesive sheet according to claims 1 to 3.

## Patentansprüche

1. Durch Wärmeeinwirkung abziehbare, doppelseitige, druckempfindliche Klebefolie, umfassend ein Substrat (a), eine durch Wärmeeinwirkung abziehbare, druckempfindliche Klebeschicht (b), gebildet auf einer Seite des Substrates (a) und durch Wärmeeinwirkung ausdehnbare Mikrosphären enthaltend, und eine druckempfindliche Klebeschicht (c), gebildet auf der anderen Seite des Substrates (a), wobei die durch Wärmeeinwirkung abziehbare, druckempfindliche Klebeschicht (b) und das Substrat (a) durch Wärmeeinwirkung abziehbar sind.

2. Die durch Wärmeeinwirkung abziehbare, doppelseitige, druckempfindliche Klebefolie gemäß Anspruch 1, weiter umfassend eine druckempfindliche Klebeschicht (d), welche die durch Wärmeeinwirkung abziehbare, druckempfindliche Klebeschicht (b) auf der Seite gegenüber des Substrats (a) überlagert.

3. Die durch Wärmeeinwirkung abziehbare, doppelseitige, druckempfindliche Klebefolie gemäß Anspruch 2, worin die druckempfindliche Klebeschicht (d) mindestens viskoelastisches Material umfasst ausgewählt aus der Gruppe bestehend aus einem druckempfindlichen Adhesiv, einem durch Strahlung vernetzbaren druckempfindlichen Adhesiv, einem thermoplastischen Harz, und einem duroplastischen Harz.

4. Die durch Wärmeeinwirkung abziehbare, doppelseitige, druckempfindliche Klebefolie gemäß einem der Ansprüche 1 bis 3, worin die druckempfindliche Klebeschicht (c) mindestens ein viskoelastisches Material umfasst ausgewählt aus der Gruppe bestehend aus einem druckempfindlichen Adhesiv, einem durch Strahlung vernetzbaren druckempfindlichen Adhesiv, einem duroplastischen Harz, und einem durch Wärmeeinwirkung abziehbaren, druckempfindlichen Adhesiv.

5. Die durch Wärmeinwirkung abziehbare, doppelseitige, druckempfindliche Klebefolie gemäß einem der Ansprüche 1 bis 3, worin der Gelanteil der druckempfindlichen Klebeschicht (c) (nach der Wärmebehandlung oder der Behandlung durch Aussetzung an Strahlung) 90% oder höher ist.

6. Die durch Wärmeentwicklung abziehbare, doppelseitige, druckempfindliche Klebefolie gemäß einem der Ansprüche 1 bis 3, worin das druckempfindliche Adhesiv, welches die durch Wärmeeinwicklung abziehbare druckempfindliche Klebeschicht (b) bildet, ein durch Strahlung vemetzbares druckempfindliches Adhesiv ist.

7. Die durch Wärmeeinwirkung abziehbare, doppelseitige, druckempfindliche Klebefolie gemäß einem der Ansprüche 1 bis 3, worin die Seite des Substrats (a), auf welcher sich die durch Wärmeentwicklung abziehbare, druckempfindliche Klebeschicht (b) befindet, eine Ablösungseigenschaften-verleihende Behandlung bekommen hat.

8. Ein Verfahren zur Verarbeitung eines anhaftenden Teils unter Verwendung der durch Wärmeeinwicklung abziehbaren, doppelseitigen, druckempfindlichen Klebefolie gemäß einem der Ansprüche 1 bis 3, umfassend das Anhaften des anhaftenden Teils an die Oberfläche der druckempfindlichen Klebeschicht (c) der durch Wärmeeinwicklung abziehbaren, doppelseitigen, druckempfindlichen Klebefolie, Anhaften einer verstärkenden Platte an die Oberfläche der druckempfindlichen, durch Wärmeeinwicklung abziehbaren Klebeschicht (b) oder druckempfindlichen Klebeschicht (d), Verarbeiten des anhaftenden Teils, anschließend Trennung an der Zwischenschicht zwischen der druckempfindlichen, durch Wärmeeinwicklung abziehbaren Klebeschicht (b) und dem Substrat (a) durch Wärmeeinwirkung verursachen, Trennen des verarbeitenden anhaftenden Teils von der verstärkenden Platte zusammen mit dem anhaftenden Substrat (a), welches die druckempfindliche Klebeschicht (c) hat, und weiterhin Abtrennen des verarbeitenden anhaftenden Teils vom Substrat (a) mit der druckempfindlichen Klebeschicht (c).

9. Das Verfahren zur Verarbeitung eines anhaftenden Teils gemäß Anspruch 8, umfassend das Anhaften des anhaftenden Teils an die Oberfläche der druckempfindlichen Klebeschicht (c) in der durch Wärmeeinwirkung abziehbaren, doppelseitigen, druckempfindlichen Klebefolie, Anhaften einer verstärkenden Platte an die Oberfläche der durch Wärmeeinwirkung abziehbaren druckempfindlichen Klebeschicht (b) oder der druckempfindlichen Klebeschicht (d), Trennen des verarbeitenden anhaftenden Teils von der verstärkenden Platte zusammen mit dem daran anhaftenden Substrat (a), welches die druckempfindliche Klebeschicht (c) hat, durch Wärmeeinwirkung, während das verarbeitete anhaftende Teil durch eine Haltevorrichtung gestützt wird, und weiterhin Abtrennen des verarbeitenden anhaften Teils vom Substrat (a), welches die druckempfindliche Klebeschicht (c) hat, während das anhaftende Teil durch die Haltevorrichtung gehalten wird.

10. Das Verfahren zur Verarbeitung eines anhaftenden Teils gemäß Anspruch 8, wobei die Haftung des anhaftenden Teils und/oder der unterstützenden Platte an die entsprechende Oberfläche der durch Wärmeeinwirkung abziehbaren, doppelseitigen, druckempfindlichen Klebefolie unter reduziertem Druck ausgeführt wird.

11. Das Verfahren zur Verarbeitung eines anhaftenden Teils gemäß Anspruch 8, wobei eine Wärmebehandlung und eine Druckbehandlung durchgeführt wird, nachdem das anhaftende Teil und/oder die unterstützende Platte an die entsprechende Oberfläche der durch Wärmeeinwicklung abziehbaren, doppelseitigen, druckempfindlichen Klebefolie angeheftet wird.

12. Das Verfahren zur Verarbeitung eines anhaftenden Teils gemäß Anspruch 8, wobei das anhaftende Teil ein elektronisches Teil oder Analoga davon ist.

13. Das Verfahren zur Verarbeitung eines anhaftenden Teils gemäß Anspruch 8, worin die unterstützende Platte, an welcher die durch Wärmeeinwicklung abziehbare druckempfindliche Klebeschicht (b) und die druckempfindliche Klebeschicht (d) anhaften, und welches erhalten wird durch Abtrennen der Zwischenschicht zwischen der durch Wärmeeinwicklung abziehbaren druckempfindlichen Klebeschicht (b) und des Substrats (a) durch Wärmeeinwirkung, abgetrennt wird von der durch Wärmeeinwicklung abziehbaren druckempfindlichen Klebeschicht (b) und der druckempfindlichen Klebeschicht (d) unter Verwendung eines Tapes oder einer Folie zum Abziehen, um so die unterstützende Platte wiederzugewinnen, und worin die so wiedergewonnene unterstützende Platte im Verfahren für ein weiteres anhaftendes Teil wiederverwendet wird.

14. Ein elektronisches Teil, welches erhalten wird mit der durch Wärmeeinwicklung abziehbaren, doppelseitigen, druckempfindlichen Klebefolie gemäß einem der Ansprüche 1 bis 3.

## Revendications

1. Feuille adhésive sensible à la pression double face pelable à chaud comprenant un substrat (a), une couche adhésive sensible à la pression pelable à chaud (b) formée sur un côté du substrat (a) et contenant des microsphères thermoexpansibles, et une couche adhésive sensible à la pression (c) formée sur l'autre côté du substrat (a), dans laquelle la couche adhésive sensible à la pression pelable à chaud (b) et le substrat (a) sont pelables l'un par rapport à l'autre sous l'action de la chaleur.

2. Feuille adhésive sensible à la pression double face pelable à chaud selon la revendication 1, qui comprend en outre une couche adhésive sensible à la pression (d) superposée sur la couche adhésive sensible à la pression pelable à chaud (b) sur son côté opposé au substrat.

3. Feuille adhésive sensible à la pression double face pelable à chaud selon la revendication 2, dans laquelle la couche adhésive sensible à la pression (d) comprend au moins un matériau viscoélastique choisi dans le groupe comprenant un adhésif sensible à la pression, un adhésif sensible à la pression durcissable par rayonnement, une résine thermoplastique, et une résine thermodurcissable.

4. Feuille adhésive sensible à la pression double face pelable à chaud selon l'une quelconque des revendications 1 à 3, dans laquelle la couche adhésive sensible à la pression (c) comprend au moins un matériau viscoélastique choisi dans le groupe comprenant un adhésif sensible à la pression, un adhésif sensible à la pression durcissable par rayonnement, une résine thermodurcissable et un adhésif sensible à la pression pelable à chaud.

5. Feuille adhésive sensible à la pression double face pelable à chaud selon l'une quelconque des revendications 1 à 3, dans laquelle la teneur en gel de la couche adhésive sensible à la pression (c) (après un traitement thermique ou un traitement par exposition au rayonnement) est de 90 % ou plus.

6. Feuille adhésive sensible à la pression double face pelable à chaud selon l'une quelconque des revendications 1 à 3, dans laquelle l'adhésif sensible à la pression constituant la couche adhésive sensible à la pression pelable à chaud (b) est un adhésif sensible à la pression durcissable par rayonnement.

7. Feuille adhésive sensible à la pression double face pelable à chaud selon l'une quelconque des revendications 1 à 3, dans laquelle le côté du substrat (a) qui est face à la couche adhésive sensible à la pression pelable à chaud (b) a subi un traitement conférant une aptitude au décollage.

8. Procédé de traitement d'une partie à coller utilisant la feuille adhésive sensible à la pression à double face pelable à chaud selon l'une quelconque des revendications 1 à 3, qui comprend l'adhésion de la partie à coller sur la surface de la couche adhésive sensible à la pression (c) dans la feuille adhésive sensible à la pression double face pelable à chaud, l'adhésion d'une plaque de renfort à la surface de la couche adhésive sensible à la pression pelable à chaud (b) ou de la couche adhésive sensible à la pression (d), le traitement de la partie à coller, provoquant ensuite la séparation à l'interface entre la couche adhésive sensible à la pression pelable à chaud (b) et le substrat (a) par chauffage, la séparation de la partie à coller traitée de la plaque de renfort avec, collé sur celle-ci, le substrat (a) ayant la couche adhésive sensible à la pression (c), et la séparation supplémentaire de la partie à coller traitée du substrat (a) ayant la couche adhésive sensible à la pression (c).

9. Procédé de traitement d'une partie à coller selon la revendication 8, qui comprend l'adhésion de la partie à coller à la surface de la couche adhésive sensible à la pression (c) dans la feuille adhésive sensible à la pression double face pelable à chaud, l'adhésion d'une plaque de renfort à la surface de la couche adhésive sensible à la pression pelable à chaud (b) ou de la couche adhésive sensible à la pression (d), la séparation par chauffage de la partie à coller traitée et de la plaque de renfort conjointement avec, collé sur celle-ci, le substrat (a) ayant la couche adhésive sensible à la pression (c) tout en soutenant la partie à coller traitée avec un support, et la séparation supplémentaire de la partie à coller traitée d'avec le substrat (a) ayant la couche adhésive sensible à la pression (c) tout en maintenant la partie à coller dans l'état d'être soutenue par le support.

10. Procédé de traitement d'une partie à coller selon la revendication 8, dans lequel l'adhésion de la partie à coller et/ou de la plaque de renfort sur la surface donnée de la feuille adhésive sensible à la pression double face pelable à chaud est réalisée sous pression réduite.

11. Procédé de traitement d'une partie à coller selon la revendication 8, dans lequel un traitement de chauffage et de pression est réalisé après que la partie à coller et/ou la plaque de renfort a adhéré à la surface donnée de la feuille adhésive sensible à la pression double face pelable à chaud.

12. Procédé de traitement d'une partie à coller selon la revendication 8, dans lequel la partie à coller est un composant électronique ou analogue.

13. Procédé de traitement d'une partie à coller selon la revendication 8, dans lequel la plaque de renfort à laquelle la couche adhésive sensible à la pression pelable à chaud (b) et la couche adhésive sensible à la pression (d) sont collées et qui est obtenu en provoquant la séparation à l'interface entre la couche adhésive sensible à la pression pelable à chaud (b) et le substrat (a) par chauffage est séparée de la couche adhésive sensible à la pression pelable à chaud (b) et la couche adhésive sensible à la pression (d) à l'aide d'une feuille ou d'une bande de pelage pour ainsi récupérer la plaque de renfort et cette plaque de renfort récupérée est réutilisée dans le traitement d'une autre partie à coller.

14. Composant électronique, qui est produit avec la feuille adhésive sensible à la pression double face pelable à chaud selon les revendications 1 à 3.
